# EUROPEAN PATENT APPLICATION

(11) **EP 4 632 772 A1**
(43) Date of publication of application: **15.10.2025**
(21) Application number: 24275038.8
(22) Date of filing: 10.04.2024
(51) Int. Cl.: H01F 6/04, G01R 33/38, G01R 33/3815, H01F 6/06

(54) **MODULAR THERMAL BUS FOR A MAGNETIC RESONANCE DEVICE**

(71) Applicant: Siemens Healthcare Limited, Camberley, Surrey GU15 3YL (GB)
(72) Inventor: Ren, Zhong You, Oxford, OX3 0HP (GB)
(74) Representative: Siemens Healthineers Patent Attorneys

(57) **Abstract**

The invention relates to a magnet arrangement (11) for a magnetic resonance device (10), comprising a first magnet coil (31a), a second magnet coil (31b) and a modular thermal bus (30), wherein the first magnet coil (31a) and the second magnet coil (31b) each comprise a superconducting wire (36) arranged in a matrix structure and wherein the modular thermal bus (30) comprises an embedded element (32) and a linking element (33), wherein the embedded element (32) is embedded within the matrix structure of the first magnet coil (31a) and wherein the embedded element (32) and the second magnet coil (31b) are thermally and mechanically connected via the linking element (33). The invention also relates to a magnetic resonance device (10) for acquiring magnetic resonance data of an object positioned within an imaging region (14) of the magnetic resonance device (10), comprising an inventive magnet arrangement (11).

## Description

Independent of the grammatical term usage, individuals with male, female or other gender identities are included within the term.

The invention relates to a magnet arrangement and a magnetic resonance device.

The use of conduction-cooled superconducting magnets (also known as "dry" magnets) in magnetic resonance devices has increased significantly due to rising prices of helium in the past years. While magnetic resonance devices with conduction-cooled superconducting magnets are commercially available, there is still a lot of potential for technical improvements. One of the main challenges for conduction-cooled superconducting magnets is an effective thermal connection between the superconducting magnets and a cryocooler.

There are several known solutions to address this challenge. In one solution, closed pipes are attached to a circumference of the superconducting magnet. Liquid helium is circulated inside the pipes to absorb heat from the superconducting magnet and to cool it down. The disadvantages of this solution are that the pipes are difficult to manufacture and to fit to the superconducting magnet. Furthermore, the pipes pose an intrinsic risk of leakage.

A further solution involves bonding a highly thermal conductive material to an outer surface of the superconducting magnet to form a thermal bus which transports heat energy to the cryocooler. While this solution avoids the use of complex cooling pipes, it provides low thermal capacities and heat transfer capacity and thus, is generally less efficient in cooling the superconducting magnets. Since the thermal bus is bonded to the outer surface of the superconducting magnet to provide thermal contact and secure the thermal bus to the superconducting magnet, repairing and/or replacing parts of the superconducting magnet is not feasible or even impossible. This can be a major drawback in magnetic resonance devices with higher magnetic field strengths (e. g. 3T and 7T), because the material value of superconducting magnet coils in such devices is significant.

It is an object of the invention to provide a conduction-cooled superconducting magnet which improves cooling efficiency and allows for a repair or replacement of parts of the superconducting magnet.

This object is achieved by a magnet arrangement and a magnetic resonance device according to the invention. Further advantageous embodiments are specified in the dependent claims.

The inventive magnet arrangement is configured for use in a magnetic resonance device. The magnet arrangement comprises a first magnet coil, a second magnet coil and a modular thermal bus.

The magnet arrangement may comprise or represent a main magnet. It is conceivable that the magnet arrangement comprises a plurality of superconducting coils. In a preferred embodiment, the magnet arrangement comprises at least two solenoidal or cylindrical superconducting coils. The at least two solenoidal or cylindrical superconducting coils may be rotationally symmetric or comprise rotationally symmetric bodies. The first magnet coil and the second magnet coil may represent superconducting coils of the main magnet.

The at least two superconducting coils of the main magnet may define a common axis. Preferably, the common axis defined by the at least two superconducting coils corresponds to a cylinder axis and/or an axis of rotational symmetry of the main magnet and/or the magnet arrangement.

According to an embodiment, the at least two superconducting coils are mechanically coupled and/or mechanically connected. Preferably, the at least two superconducting coils form a cohesive or coherent structure.

For example, the magnet arrangement may comprise a magnet support structure configured to provide mechanical support to the at least two superconducting coils. The magnet support structure may be configured to maintain a predefined spatial arrangement of the at least two superconducting coils. According to an embodiment, the magnet support structure is configured to be mechanically connected to a support structure, particularly an outer vacuum chamber, of a magnetic resonance device.

In a further example, the at least two superconducting coils may be integrally bonded. Preferably, the at least two superconducting coils are integrally bonded to at least one spacer arranged between the at least two superconducting coils.

The magnet arrangement may further comprise a cryogen vessel and/or a thermal shield. It is conceivable that the magnet arrangement is circumferentially enclosed in an outer vacuum chamber of a magnetic resonance device. The vacuum chamber may be formed as a double-walled hollow cylinder comprising an outer shell and an inner shell connected by annular end pieces. The magnet arrangement may be enclosed between the outer shell and the inner shell of the outer vacuum chamber. The inner shell of the outer vacuum chamber may correspond to a patient bore of a magnetic resonance device comprising the magnet arrangement.

The first magnet coil and the second magnet coil each comprise a superconducting wire arranged in a matrix structure. Preferably, the superconducting wire of the first magnet coil and/or the second magnet coil is wound in such a way to form a superconducting coil. The matrix structure of the first magnet coil and/or the second magnet coil may comprise or consist of a superconducting wire impregnated with a resin, particularly an epoxy resin. The superconducting wire of the first magnet coil and/or the second magnet coil may wound in such a way to form layers. It is conceivable that the layers of superconducting wire are separated from each other by the resin and/or an electrical insulator.

The modular thermal bus comprises an embedded element and a linking element. The embedded element and the linking element may comprise or consist of a thermally conductive material. Particularly the embedded element and the linking element may comprise or consist of a solid thermal conductor, such as a metal and/or a thermally conductive composite material. In a preferred embodiment, the embedded element and/or the linking element consist of copper, gold, aluminium, platinum, silver, or the like. The embedded element and/or the linking element may be configured as a wire, a plate, a bar, a foil, a mesh, a braid, a tube, or the like. The embedded element and/or the linking element may comprise bends and/or angles.

The modular thermal bus may be configured to provide a thermal and mechanical connection to a cooling system of a magnetic resonance device. Particularly, the modular thermal bus element may be configured to provide a thermal and mechanical connection to a cryocooler, a heat exchanger of a cryocooler, a cold head of a cryocooler and/or a main thermal bus of a magnetic resonance device.

According to an embodiment, the modular thermal bus, particularly the linking element, is configured to transport heat energy from the embedded element to the cooling system of the magnetic resonance device. The linking element may be configured to bridge a distance between the embedded element and the cooling system of the magnetic resonance device. Particularly, the linking element may provide a thermal and mechanical connection between the embedded element and the cooling system.

According to the invention, the embedded element is embedded within the matrix structure of the first magnet coil and the embedded element and the second magnet coil are thermally and mechanically connected via the linking element.

The linking element may be thermally and mechanically connected to the embedded element via a force-locking connection, a form-locking connection and/or a material bond. Preferably, the mechanical connection between the embedded element and the linking element is configured to allow for a transport of thermal energy from the embedded element to the linking element. For example, the linking element may be screwed, bolted, clamped, crimped and/or glued to the embedded element. In a preferred embodiment, the linking element is mechanically connected to the embedded element via a reversible mechanical connection, particularly a screw connection and/or a bolt connection. A glued joint between the linking element and the embedded element may also provide for a reversible mechanical connection if the glued joint is accessible and can be separated via an application of heat and/or a solvent.

According to an embodiment, the magnet arrangement comprises a further embedded element embedded within the matrix structure of the second magnet coil. The linking element may be mechanically connected to the further embedded element via a force-locking connection, a form-locking connection and/or a material bond. Preferably, the linking element and the further embedded element are mechanically connected via a reversible mechanical connection.

In a further embodiment, the linking element comprises or consists of attaching means configured to thermally and mechanically connect a section of the embedded element embedded within the matrix structure of the first magnet coil to a section of the further embedded element embedded within the matrix structure of the second magnet coil. For example, the linking element may comprise or consist of a bolt and/or a screw configured to thermally and mechanically connect the embedded element to the further embedded element.

According to a further embodiment, the embedded element is embedded within the matrix structure of the first magnet coil and within the matrix structure of the second magnet coil. Of course, the modular thermal bus may comprise an embedded element embedded within the matrix structure of the second magnet coil and within a matrix structure of a third magnet coil. The linking element may be thermally and mechanically connected to one or more embedded elements according to an embodiment described above.

In still a further embodiment, the modular thermal bus may comprise a plurality of embedded elements embedded within the matrix structure of the first magnet coil. The modular thermal bus may comprise also a plurality of embedded elements embedded within the matrix structure of the second magnet coil. The embedded elements may be thermally and mechanically connected via one or more linking elements.

In providing an embedded element embedded within the matrix structure of the first magnet coil, a heat transfer area between the first magnet coil and the modular thermal bus may be increased in comparison to conventional thermal bus structures arranged on an outer surface of the main magnet. Thus, an efficiency transporting heat energy from the superconducting wires to a cooling system of a magnetic resonance device may favourably be increased. Particularly, a temperature distribution across the matrix structure of the first magnet coil may favourably be evened out or homogenized.

As a further advantage, a reversible mechanical connection between the embedded element and the linking element may allow for a separation of parts or sections of the modular thermal bus. Thus, the inventive magnet arrangement may favourably be disassembled in case one or more superconducting coils require a repair or replacement.

According to an embodiment of the inventive magnet arrangement, the first magnet coil and the second magnet coil are spaced apart from one another.

For example, the first magnet coil and the second magnet coil may be attached or mounted to a magnet support structure according to an embodiment described above. The first magnet coil and the second magnet coil may be mechanically connected to the magnet support structure via a force-locking connection, a form-locking connection and/or a material bond. It is conceivable that the first magnet coil and the second magnet coil are attached to the magnet support structure in such a way that the first magnet coil and the second magnet coil are separated by a gap of several millimetres or several centimetres.

In a further example, the first magnet coil and the second magnet coil are separated by at least one spacer. The first magnet coil and the second magnet coil may be attached to the at least one spacer via a force-locking connection, a form-locking connection and/or a material bond. Preferably, the first magnet coil, the second magnet coil and the at least one spacer form a coherent or cohesive structure.

In providing a linking element and an embedded element according to the invention, the modular thermal bus may favourably provide a thermal connection between the first magnet coil and the second magnet coil across a distance between the first magnet coil and the second magnet coil without permanently or irreversibly attaching the second magnet coil to the first magnet coil via the modular thermal bus.

According to a preferred embodiment of the inventive magnet arrangement, the first magnet coil and the second magnet coil are spaced apart via at least one spacer arranged between the first magnet coil and the second magnet coil.

Preferably, the at least one spacer is implemented as one or more rings, one or more hollow cylinders, or one or more segments of rings or hollow cylinders. It is also conceivable that the at least one spacer is implemented as one or more blocks of any suitable shape.

The at least one spacer may comprise or consists of a thermally conductive material. Particularly, the at least one spacer may be configured to transport thermal energy between the plurality of superconducting coils of the main magnet. Preferably, the at least one spacer comprises an electrically insulating material, an electrically insulating coating, or an electrically insulating layer. For example, the at least one spacer may comprise or consist of a metal, a plastic material and/or a composite material.

According to an embodiment, the at least one spacer is configured to fill a gap between the first magnet coil and the second magnet coil. However, the at least one spacer may also be configured to fill a gap between the first magnet coil and a third magnet coil, or between the third magnet coil and the second magnet coil.

The superconducting coils of the magnet arrangement and the at least one spacer may form a coherent or cohesive structure. The at least one spacer may be attached to the first magnet coil and/or the second magnet coil via a force-locking connection, a form-locking connection and/or a material bond. Preferably, the at least one spacer is reversibly mounted to the first magnet coil and/or the second magnet coil to allow for a disassembly of the inventive magnet arrangement.

For example, the at least one spacer may be screwed or bolted to the first magnet coil, the second magnet coil and/or a third magnet coil.

In providing at least one spacer arranged between the first magnet coil and the second magnet coil, an integrally bonded magnet arrangement may be provided. Thus, a weight and/or costs associated with a dedicated support cylinder or support structure for the main magnet may favourably be omitted.

According to an embodiment of the inventive magnet arrangement, the embedded element comprises a connecting section protruding from the matrix structure of the first magnet coil. The linking element is thermally and mechanically connected to the connecting section.

The connecting section may be configured to provide a thermal and mechanical connection with the linking element. For example, the connecting section may be configured to be screwed, clamped, bolted and/or glued to the linking element. Preferably, the linking element and the connecting section are connected via a reversible mechanical connection.

Depending on a relative spatial orientation of an embedded section of the embedded element, the connecting section may be angled and/or bend with respect to the embedded section. Particularly, the embedded section may be angled and/or bend in such a way to direct the connecting section towards an outer surface or circumference of the first magnet coil. It is also conceivable that the connecting section protruding from the matrix structure of the first magnet coil is angled and/or bend towards an outer circumferential surface of a spacer and/or a magnet support structure.

According to an embodiment, at least a section of the connecting section is arranged outside the matrix structure of the first magnet coil, whereas at least a section of the embedded element is arranged within the matrix structure of the first magnet coil. Preferably, the section of the connecting section arranged outside the matrix structure of the first magnet coil is configured to thermally and mechanically connect to the linking element. For example, the connecting section may comprise a heat transfer area in contact with the linking element. The heat transfer area of the connecting section may be configured to transport an expected heat load arising in the first magnet coil to the linking element.

In providing a connecting section reversibly attached to the linking element, the superconducting wire of the first magnet coil may favourably be thermally connected to the modular thermal bus, while still allowing for a disassembly of the modular thermal bus and/or the magnet arrangement. Furthermore, in leading the connecting section out of the matrix structure of the first magnet coil, the embedded section of the embedded element may be embedded within the matrix structure of the first magnet coil at any desired depth and/or orientation. Thus, an improved or optimized thermal connection between the first magnet coil and the modular thermal bus may be provided.

In other embodiments, instead of protruding from an outer circumferential surface of the matrix structure of the first magnet coil, the embedded element may also extend through a channel or cavity in the at least one spacer or the magnet support structure. For example, the at least one spacer or the magnet support structure may comprise a borehole, an indentation and/or a groove configured for routing the embedded element through a material of the at least one spacer or the magnet support structure. Such a channel or cavity may be open and/or accessible from an outer circumferential surface of the magnet arrangement to allow for a disassembly of the modular thermal bus.

According to an embodiment of the inventive magnet arrangement, the first magnet coil and the at least one spacer comprise a cylindrical shape.

The magnet arrangement may be cylindrical in shape. Particularly, the superconducting coils and the at least one spacer may form a cylindrical body defining a cylinder axis and/or an axis of rotational symmetry.

The connecting section is arranged on an outer circumferential surface of the at least one spacer and the linking element is mechanically connected to the at least one spacer and the connecting section at the outer circumferential surface of the at least one spacer.

The outer circumferential surface of the at least one spacer may form a part of a lateral surface of the magnet arrangement. It is conceivable that the connecting section protrudes from the matrix structure of the first magnet coil and bends or curves over at least a part of the outer circumferential surface of the at least one spacer. The connecting section may be in contact with and/or mechanically connected to the at least one spacer. Particularly, the connecting section may be reversibly attached to the outer circumferential surface of the at least one spacer. In a preferred embodiment, the connecting section and the linking element are reversibly attached to the at least one spacer. For example, the connecting section and the linking element may be screwed, clamped and/or bolted to the at least one spacer. In a less preferred embodiment, the linking element and/or the connecting section are connected to the at least one spacer via an adhesive.

The at least one spacer may favourably provide a platform or support structure for mechanically securing the linking element and the connecting section along a length of the magnet arrangement. Furthermore, in mechanically connecting the connecting element and the linking element to the at least one spacer, a connection strength and a thermal contact between the linking element and the connecting section may favourably be improved. As a further advantage, the at least one spacer may be thermally connected to the modular thermal bus. Thus, a transport of heat energy from the magnet coils to the modular thermal bus may be further improved.

In a further embodiment, the inventive magnet arrangement comprises a thermally conductive element arranged between the embedded element and the linking element.

In a preferred embodiment, the thermally conductive element is arranged between the connecting section of the embedded element and the linking element.

The thermally conductive element may comprise or consist of a soft material, particularly a soft metal such as indium. However, the thermally conductive element may also comprise or consist of a layer of thermally conductive adhesive and/or a thermally conductive paste.

In arranging a thermally conductive element between the linking element and the embedded element, a transport of heat energy from the magnet coils to the modular thermal bus may favourably be improved.

Furthermore, a thermally conductive element comprising or consisting of a thermal paste and/or a soft metal may facilitate a detachment of the embedded element from the linking element. Thus, maintenance and/or repair services on the magnet arrangement requiring a disassembly of the modular thermal bus may favourably be simplified.

In a further embodiment of the inventive magnet arrangement, the first magnet coil comprises a cylindrical shape. A section of the embedded element extends through the matrix structure of the first magnet coil in parallel to a cylinder axis of the first magnet coil.

The cylinder axis of the first magnet coil may correspond to a cylinder axis and/or an axis of rotational symmetry of the magnet arrangement. The section of the embedded element may extend through the matrix structure of the first magnet coil along an axial direction of the first magnet coil and/or the magnet arrangement.

Preferably, the section of the embedded element extending through the matrix structure of the first magnet coil in parallel to the cylinder axis of the first magnet coil section extends between predetermined layers of the superconducting wire of the first magnet coil.

The section of the embedded element extending through the matrix structure of the first magnet coil in parallel to the cylinder axis may represent a major part, e. g. more than 50%, more than 60 %, more than 70 %, more than 80 %, or preferably more than 90 % of the embedded element. Due to manufacturing tolerances, a direction of extension of the section of the embedded element may deviate a few degrees, preferably less than ten degrees, less than five degrees, or less than two degrees, from the cylinder axis of the first magnet coil.

In magnetic resonance devices, the superconducting wires of the magnet coils are typically layered or stacked in a radial direction. An inventive embedded element may favourably provide a thermal connection between two predetermined layers or windings of a magnet coil and the embedded element. Furthermore, embedded elements extending along an axial direction of a magnet coil may simply be inserted before adding or winding a new radial layer of superconducting wires during the winding process. Thus, a manufacturing process of magnet coils comprising an embedded element may favourably be facilitated.

According to a further embodiment of the inventive magnet arrangement, the first magnet coil comprises a cylindrical shape. A section of the embedded element extends through the matrix structure of the first magnet coil in a radial direction of the first magnet coil.

The section of the embedded element extending through the matrix structure of the first magnet coil in a radial direction of the first magnet coil may represent a major part, e. g. more than 50 %, more than 60 %, more than 70 %, more than 80 %, or preferably more than 90 % of the embedded element.

It is conceivable that the section of the embedded element extending through the matrix structure of the first magnet coil in a radial direction of the first magnet coil extends between predetermined rows of the superconducting wire of the first magnet coil. Particularly, the section of the embedded element may extend through the matrix structure of the first magnet coil in a direction oriented substantially orthogonally with respect to the cylinder axis or axis of rotational symmetry of the first magnet coil and/or the magnet arrangement. Due to manufacturing tolerances, a direction of extension of the section of the embedded element through the matrix structure of the first magnet coil may deviate a few degrees, preferably less than ten degrees, less than five degrees, or less than two degrees, from a radial direction or transverse plane defined by the first magnet coil and/or the magnet arrangement.

A section of the embedded element protruding from the first magnet coil may represent a connecting section according to an embodiment described above.

An embedded element having a section extending through the matrix structure of a magnet coil in a radial direction may favourably provide a thermal contact with superconducting wires over a predetermined depth of the superconducting material. However, a manufacturing process of a magnet coil comprising a section of an embedded element extending through the matrix structure of the magnet coil in a radial direction may be more challenging or expensive in comparison to a magnet coil comprising a section of an embedded element extending between the layers of superconducting material along an axial direction of the magnet coil.

In a preferred embodiment of the inventive magnet arrangement, the first magnet coil comprises a cylindrical shape. An extension of the embedded element within the matrix structure of the first magnet coil is limited to a cylinder sector of the first magnet coil, wherein the cylinder sector accounts for less than 80%, less than 60%, less than 40%, or preferably less than 20% of a circumference of the first magnet coil.

The first magnet coil may be subdivided into a plurality of imaginary cylinder sectors. Each cylinder sector of the plurality of cylinder sectors may define or comprise a part of a circumference of the first magnet coil.

The embedded element may form a part of one or more imaginary cylinder sectors of the first magnet coil. Particularly, the embedded element may extend through the one or more imaginary cylinder sectors. However, the embedded element may be restricted to the one or more imaginary cylinder sectors and not extend into further imaginary cylinder sectors of the first magnet coil.

It is conceivable that the one or more imaginary cylinder sectors comprising the embedded element account for less than 80%, less than 60%, less than 40%, or preferably less than 20% of a circumference of the first magnet coil. The extension of the embedded element within the matrix structure of the first magnet coil may be limited to a radial section of the first magnet coil. The extension of the embedded element within the matrix structure of the first magnet coil may also be limited to a transverse section of the first magnet coil.

According to an embodiment, the extension of the embedded element within the matrix structure of the first magnet coil is limited to a fraction of an axial dimension or length of the first magnet coil. For example, the extension of the embedded element within the matrix structure of the first magnet coil may be limited to a fraction of less than 80%, less than 60%, or less than 40% of an axial dimension or length of the first magnet coil.

In limiting an extension of the embedded element within the matrix structure to a cylinder sector or a fraction of an axial dimension of the first magnet coil, costs associated with the manufacturing process of the first magnet coil may favourably be reduced, while still providing a sufficiently large or optimized heat transfer area between the superconducting wire and the embedded element.

According to an embodiment, the inventive magnet arrangement comprises a plurality of embedded elements embedded within the matrix structure of the first magnet coil and/or the second magnet coil.

The second magnet coil may be configured corresponding to an embodiment of the first magnet coil described above. Particularly, one or more embedded element may be embedded within the matrix structure of the second magnet coil in accordance with any embodiment described herein. The matrix structure of the second magnet coil may comprise resin-impregnated layers and/or windings of superconducting wire. It is conceivable, however, that a radial dimension and/or an axial dimension of the second magnet coil differs from the first magnet coil.

In a preferred embodiment, the first magnet coil comprises a first embedded element embedded within the matrix structure of the first magnet coil and the second magnet coil comprises a second embedded element embedded within the matrix structure of the second magnet coil. The first embedded element and/or the second embedded element may each comprise a section oriented in radial direction of the magnet arrangement or in parallel to a cylinder axis of the magnet arrangement.

According to a further embodiment, a plurality of embedded elements may be embedded in the matrix structure of the first magnet coil. The plurality of embedded elements may be arranged at different radial distances from a cylinder axis of the first magnet coil.

The at least two embedded elements of the plurality of embedded elements may be embedded within the matrix structure of the first magnet coil at different depths. For example, the first magnet coil may comprise a first embedded element and a second embedded element extending between different layers of the superconducting wire along an axial direction of the first magnet coil. Particularly, the first embedded element may be arranged at a first radial distance to the cylinder axis of the first magnet coil and the second embedded element may be arranged at a second radial distance to the cylinder axis of the first magnet coil. The first radial distance may differ from the second radial distance. Of course, the first magnet coil may comprise further embedded elements, e. g. a third embedded element and/or a fourth embedded element, arranged at different radial distances to the cylinder axis of the first magnet coil. A plurality of embedded elements may be embedded within the matrix structure of the second magnet coil in a similar manner.

According to an embodiment, at least two embedded elements of the plurality of embedded elements may be arranged in different cylinder sectors of the first magnet coil and/or the second magnet coil. Thus, embedded elements may favourably be distributed along the circumferential direction of the magnet arrangement, which may improve thermal connection to different sections of the magnet arrangement.

A plurality of embedded elements embedded within the matrix structure of a magnet coil at different depths may favourably allow for different layers of superconducting wire to be thermally connected to the modular thermal bus.

In a further embodiment, the first magnet coil comprises a first embedded element and a second embedded element extending through the matrix structure of the first magnet coil in parallel to cylinder axis of the first magnet coil. A radial distance between the first embedded and the cylinder axis of the magnet arrangement may correspond to a radial distance between the second embedded element and the cylinder axis of the magnet arrangement.

In still a further embodiment, the plurality of embedded elements may be arranged at different axial sections of the magnet arrangement. For example, the plurality of embedded elements may be arranged at different axial sections of the first magnet coil, the second magnet coil and/or a third magnet coil. Particularly, each embedded element of the plurality of embedded elements may be arranged at a different axial section of the magnet arrangement. An axial section of a first embedded element may overlap with an axial section of a second embedded element, if the first embedded element and the second embedded element arranged at different radial distances to the cylinder axis of the magnet arrangement. It is also conceivable that a first embedded element and a second embedded element, which are axially spaced from one another, are arranged at similar or identical radial distances from the cylinder axis of the magnet arrangement.

According to the invention, the plurality of embedded elements is thermally and mechanically connected via one or more linking elements.

For example, in cases where a plurality of embedded elements is embedded within the first magnet coil, the plurality of embedded may be thermally and mechanically connected to a common connecting section. The common connecting section may be thermally and mechanically connected to the one or more linking elements and/or an embedded element embedded within the matrix structure of the second magnet coil in accordance with any embodiment described herein. However, each embedded element of the plurality of embedded elements may comprise a dedicated or separate connecting section thermally and mechanically connected to the one or more linking elements and/or the embedded element embedded within the matrix structure of the second magnet coil.

In a preferred embodiment, a first embedded element is embedded within the matrix structure of the first magnet coil and a second embedded element is embedded within the matrix structure of the second magnet coil. A connecting section of the first embedded element and a connecting section of the second embedded element may be thermally and mechanically connected to the one or more linking elements in accordance with any embodiment described herein. However, the connecting section of the first embedded element and the connecting section of the second embedded element may also be thermally and mechanically connected to each other via the linking element.

In providing a plurality of embedded elements arranged at different locations in the matrix structures of magnet coils of an inventive magnet arrangement, a heat transfer capacity of the modular thermal bus may favourably be optimized and/or adjusted to specific requirements of different magnetic resonance devices (e. g. whole-body scanners or dedicated scanners for imaging of certain body parts).

According to an embodiment of the inventive magnet arrangement, a third magnet coil is arranged between the first magnet coil and the second magnet coil.

The third magnet coil may comprise one or more embedded elements embedded within a matrix structure of the third magnet coil. The one or more embedded elements of the third magnet coil may be configured in accordance with any embodiment of an embedded element described herein. Particularly, the embedded element of the third magnet coil may be thermally and mechanically connected to the linking element.

The thermal bus may comprise a monolithic or coherent linking element thermally and mechanically connected to the embedded element of the first magnet coil and the embedded element of the third magnet coil, but also an embedded element of a second magnet coil. However, the modular thermal bus may also comprise a plurality of linking elements. For example, the modular thermal bus may comprise at least a first linking element and a second linking element. The first linking element may be thermally and mechanically connected to the embedded element of the first magnet coil and the embedded element of the third magnet coil. Likewise, the second linking element may be thermally and mechanically connected to the embedded element of the third magnet coil and the embedded element of the second magnet coil. Of course, the inventive magnet arrangement may comprise further magnet coils, embedded elements, but also linking elements, configured in accordance with any embodiment described herein.

The modular thermal bus of the inventive magnet arrangement may favourably allow for a modular scaling of the number of embedded elements, but also the number of linking elements, based on specific requirements of a magnetic resonance device. For example, the number of embedded elements, but also linking elements, may be adjusted in dependence of the number of magnet coils, individual depths of the magnet coils and/or individual axial dimensions of the magnet coils of the inventive magnet arrangement.

According to a further embodiment of the inventive magnet arrangement, the modular thermal bus comprises a first embedded element and a second embedded element. The first embedded element is embedded within the first magnet coil and the second embedded element is embedded within the second magnet coil. The first embedded element and the second embedded element are thermally and mechanically connected via the linking element.

The first embedded element and the second embedded element may be configured in accordance with any embodiment described herein.

For example, the first magnet coil and the second magnet coil may be spaced-apart or separated via at least one spacer according to an embodiment described above. In a preferred embodiment, the first magnet coil and the second magnet coil are mechanically attached to opposing axial ends or faces of a spacer and form a coherent structure. It is conceivable that the first magnet coil and the second magnet coil are screwed, bolted and/or glued to the opposing axial ends of the spacer.

According to an embodiment of the inventive magnet arrangement, the first embedded element and the second embedded element each comprise a connecting section. The connecting sections of the first embedded element and the second embedded element overlap along an axial section of the magnet arrangement. The linking element is configured to thermally and mechanically connect the connecting sections of the first embedded element and the second embedded element.

For example, the connecting section of the first embedded element and the connecting section of the second embedded element may be bend or curved over an outer circumferential surface of a spacer separating the first magnet coil and the second magnet coil. The connecting section of the first embedded element and the connecting section of the second embedded element may be mechanically attached to the spacer separating the first magnet coil and the second magnet coil. Preferably, the connecting section of the first embedded element and/or the connecting section of the second embedded element are screwed, bolted and/or glued to an outer circumferential surface of the spacer separating the first magnet coil and the second magnet coil.

The connecting section of the first embedded element and the connecting section of the second embedded element may be thermally and mechanically connected via the linking element. For example, the linking element may represent a bar, a plate, a block, or an arbitrarily shaped structure configured to bridge a gap between the connecting section of the first embedded element and the connecting section of the second embedded element. The linking element may also comprise a support structure for attaching means configured to mechanically connect the connecting section of the first embedded element to the connecting section of the second embedded element.

Furthermore, the linking element may comprise attaching means configured to attach the linking element to at least one spacer. For example, the linking element may comprise or consist of one or more bolts and/or screws. The attaching means may also be configured to attach the connecting section of the first embedded element and the connecting section of the second embedded element to at least one spacer. In a preferred embodiment, the attaching means is configured to provide a thermal and mechanical connection between the connecting section of the first embedded element and the connecting section of the second embedded element. For example, the attaching means may comprise or consist of one or more screws and/or bolts.

According to an embodiment, the connecting section of the first embedded element and the connecting section of the second embedded element are configured to overlap on an outer circumferential surface of at least one spacer. The linking element may comprise or consist of one or more screws and/or bolts configured to mechanically connect the connecting section of the first embedded element and the connecting section of the second embedded element to the at least one spacer.

In case the magnet coils of the magnet arrangement are mounted to a dedicated magnet support structure, the linking element may be configured to mechanically connect the connecting sections of the first embedded element and the second embedded element to the magnet support structure. The linking element may be configured to thermally and mechanically connect the first embedded element and the second element to one another, but also to the magnet support structure. The linking element may be configured in accordance with any embodiment described above.

Preferably, the magnet arrangement, particularly the modular thermal bus, comprises a thermally conductive element according to an embodiment described herein. The thermally conductive element may be configured to increase or improve a transport of heat energy between the connecting section of the first embedded element and the connecting section of the second embedded element. The thermally conductive element may also be configured to improve a transport of heat energy between the linking element, the connecting section of the first embedded element and the connecting section of the second embedded element.

In providing overlapping connecting sections of embedded elements thermally and mechanically connected via a bolt and/or a screw, a weight and/or material costs associated with the inventive magnet arrangement may favourably be reduced.

A modular thermal bus according to the invention may favourably allow for a detachment of the linking element and thus, enable a disassembly of the magnet arrangement. Furthermore, a modular thermal bus according to the invention may favourably allow for a thermal and mechanical connection between a plurality of embedded elements and/or linking elements of an arbitrary number of magnet coils.

The first magnet coil and the second magnet coil may represent inner coils or field coils of the inventive magnet arrangement. The inventive magnet arrangement may further comprise a plurality of outer coils or shield coils. A diameter of the shield coils may exceed a diameter of the first magnet coil and the second magnet coil according to an embodiment described above. The shield coils may be thermally connected to a modular thermal bus in accordance with any embodiment described herein. Particularly, one or more embedded elements may be embedded within matrix structures of such shield coils. The one or more embedded elements may comprise connecting sections thermally and mechanically connected to one or more linking elements. The one or more linking elements may be thermally and mechanically connected to a modular thermal bus according to an embodiment described above, a main thermal bus and/or a cooling system of a magnetic resonance device.

The inventive magnetic resonance device is configured to acquire magnetic resonance data of an object positioned within an imaging region of the magnetic resonance device. The magnetic resonance device comprises a magnet arrangement according to an embodiment described above.

Preferably, the magnetic resonance device is configured to acquire magnetic resonance image data, particularly diagnostic magnetic resonance image data, from the object positioned within the imaging region. The object may be an inanimate object or a patient, particularly a human or an animal.

The inventive magnetic resonance device may represent a closed bore scanner. A closed bore scanner may comprise a substantially cylindrical bore circumferentially enclosing the imaging region. The magnet arrangement of the closed bore scanner may comprise one or more solenoidal superconducting magnet coils circumferentially encompassing the imaging region along an axial direction or an axis of rotational symmetry of the cylindrical bore. The one or more superconducting magnet coils may comprise a superconducting wire having a negligible electrical resistance at (or below) a superconducting temperature. A direction of a main magnetic field provided via the one or more superconducting magnet coils may be oriented substantially in parallel to a direction of access of the object to the imaging region and/or the axial direction of the cylindrical bore.

The inventive magnetic resonance device may comprise further components required for a proper operation of the magnetic resonance device. For example, the magnetic resonance device may comprise an outer vacuum chamber, a magnet support structure, a thermal shield, a cryocooler, or the like. In certain embodiments, the magnetic resonance device comprises a cryogen vessel.

A cryogen vessel may be configured for storing or preserving a fluid, particularly a cryogen, at a predefined temperature level. Preferably, the fluid or cryogen exhibits a low boiling point. Examples of suitable fluids or cryogens are Argon, Nitrogen, Neon, Helium, or the like. The predefined temperature level may substantially correspond to a superconducting temperature of the main magnet.

A cryocooler may be configured to cool the one or more superconducting magnet coils of the magnet arrangement and/or maintain the one or more superconducting magnet coils at a temperature level close to the superconducting temperature. The magnet arrangement, the thermal shield, the magnet support structure, and/or the cryogen vessel may be thermally connected to the cryocooler via a solid thermal conductor, a convection loop and/or a heat pipe. Particularly, the one or more superconducting magnet coils of the magnet arrangement may be thermally and mechanically connected to the cryocooler via a modular thermal bus according to an embodiment described above.

The inventive magnetic resonance device may represent a "dry" system comprising a minimum of cryogen or no cryogen at all. For example, the inventive magnetic resonance device may comprise one or more small cryogen vessels thermally connected to the main magnet via a solid thermal conductor. The one or more small cryogen vessels may contain a volume of less than 10 I, less than 5 I, or less than 1 I of cryogen. According to an embodiment of the inventive magnetic resonance device, a cryogen vessel is omitted and the magnet arrangement is cooled entirely via thermal conduction.

In an alternative embodiment, the inventive magnetic resonance device represents a "wet" system. A "wet" system may include at least one cryogenic container comprising a volume of more than 10 I or more than 100 I. The magnet arrangement may be accommodated within the cryogen vessel and cooled directly by the cryogen.

The magnetic resonance device shares the advantages of the inventive magnet arrangement according to an embodiment described above.

Further advantages and details of the present invention may be recognized from the embodiments described below as well as the drawings. The figures show:
- Fig. 1: a schematic representation of an embodiment of an inventive magnetic resonance device,
- Fig. 2: a schematic representation of an embodiment of an inventive magnet arrangement,
- Fig. 3: a schematic representation of an embodiment of a modular thermal bus in an inventive magnet arrangement,
- Fig. 4: a schematic representation of an embodiment of a modular thermal bus in an inventive magnet arrangement,
- Fig. 5: a schematic representation of an embodiment of a modular thermal bus in an inventive magnet arrangement,
- Fig. 6: a schematic representation of an embodiment of a modular thermal bus in an inventive magnet arrangement,
- Fig. 7: a schematic representation of an embodiment of a modular thermal bus in an inventive magnet arrangement,
- Fig. 8: a schematic representation of an embodiment of an inventive magnet resonance device,
- Fig. 9: a schematic representation of an embodiment of an inventive magnet arrangement.

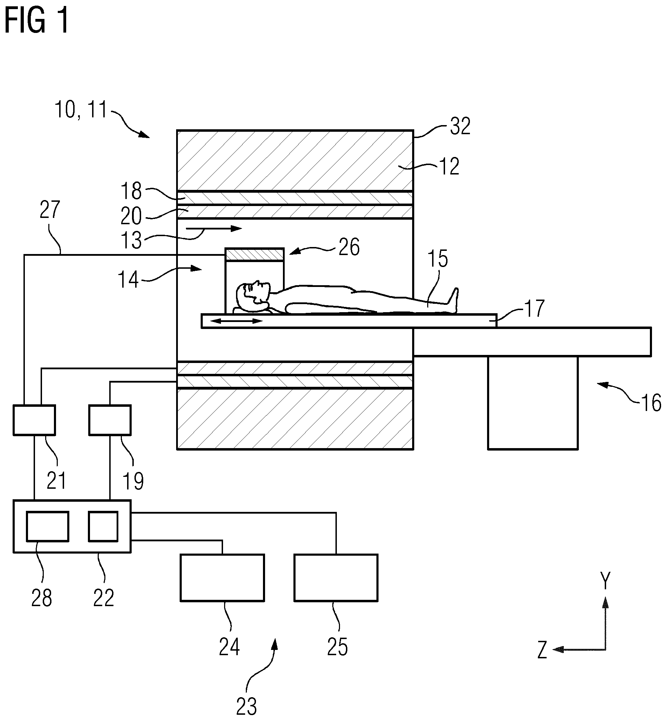

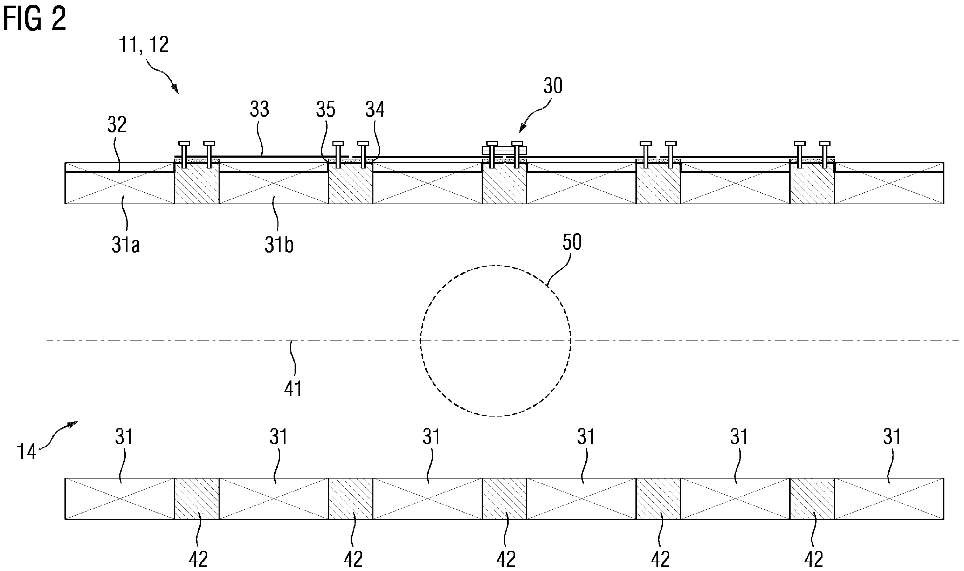

Fig. 1 shows an embodiment of a magnetic resonance device 10 according to the invention. In the illustrated example, the magnetic resonance device 10 comprises a static field magnet or main magnet 12 configured to provide a homogenous, static magnetic field 13 (80 field) comprising an imaging volume 50 (see Fig. 2). The static magnetic field 13 permeates an imaging region 14 configured to receive an imaging object, such as a patient 15. The imaging region 14 may correspond to a patient bore configured to accommodate a patient 15 during a magnetic resonance measurement. The imaging region 14 is encompassed by the main magnet 12 in a circumferential direction. The main magnet 12 forms a part of an inventive magnet arrangement 11.

The magnetic resonance device 10 may comprise a patient positioning device 16 configured to transport the patient 15 into the imaging region 14. Particularly, the patient positioning device 16 may be configured to transport a diagnostically relevant body region of the patient 15 into the imaging volume 50 or an isocentre of the magnetic resonance device 10. The main magnet 12 and other components of the magnetic resonance device 10 may be concealed in a housing.

The magnetic resonance device 10 may comprise a gradient system including one or more gradient coils 18. The one or more gradient coils may be configured to generate gradient magnetic fields in different, preferably orthogonally oriented, spatial directions. The gradient magnetic fields can be used for spatial encoding of magnetic resonance signals or magnetic resonance data acquired during a magnetic resonance measurement. The one or more gradient coils 18 can be activated or controlled via an appropriate control signal provided by a gradient control unit 19.

The magnetic resonance device 10 may comprise an integrated radiofrequency antenna 20 (i. e. a body coil). The radiofrequency antenna 20 may be activated or controlled via a radiofrequency control unit 21. The radiofrequency control unit 21 may be configured to control the radiofrequency antenna 20 to generate a high frequency magnetic field and emit radiofrequency excitation pulses into the imaging region 14. The magnetic resonance device 10 may further comprise a local coil 26. The local coil 26 may be positioned on or in proximity to the diagnostically relevant region of the patient 15. The local coil 26 may be configured to emit radiofrequency excitation pulses into the patient 15 and/or receive magnetic resonance signals from the patient 15. It is conceivable, that the local coil 26 is controlled via the radiofrequency controller 21.

Preferably, the magnetic resonance device 10 comprises a control unit 22 configured to control the magnetic resonance device 10. The control unit 22 may comprise a processing unit 28 configured to process magnetic resonance signals and reconstruct magnetic resonance images. The processing unit 28 may also be configured to process input from a user of the magnetic resonance device 10 and/or provide an output to a user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The input unit 25 may be configured to receive information and/or imaging parameters from the user.

Of course, the magnetic resonance device 10 may comprise further components and/or functions which are common in magnetic resonance devices. The general operation of a magnetic resonance device 10 is known to those skilled in the art, so a more detailed description is omitted.

Fig. 2 shows a schematic representation of a modular thermal bus 30 of an inventive magnet arrangement 11. In the present example, the magnet arrangement 11 comprises a plurality of superconducting coils (or magnet coils) 31 circumferentially enclosing the imaging region 14 comprising the imaging volume 50. The magnet coils 31 are spaced-apart by spacers 42 attached to the magnet coils 31 to form a coherent structure. The magnet arrangement 11 comprises the shape of a cylinder or hollow cylinder. Particularly, the magnet arrangement 11 defines a cylinder axis 41 or axis of rotational symmetry intersecting the imaging volume 50. The imaging volume 50 provided via the magnet arrangement may be characterized by a particularly homogenous magnetic field. Particularly, the imaging volume 50 may represent an isocentre of a magnetic resonance device 10. The plurality of superconducting coils 31 may represent the inner coils or field coils of the magnet arrangement 11.

The modular thermal bus 30 comprises a plurality of embedded elements 32 embedded within matrix structures of the magnet coils 31. In the example depicted in Fig. 2, an embedded element 32 is embedded within the matrix structure of each magnet coil 31. The embedded elements 32 comprise connecting sections 35 protruding from the matrix structure of the magnet coils 31 and bending or curving over adjacent spacers 42. The connecting sections 35 of embedded elements 32 of two neighbouring magnet coils 31 are thermally and mechanically connected via linking elements 33. The linking elements 33 comprise attaching means, such as bolts and/or screws, configured to attach the connecting sections 35 and the linking elements 33 to outer circumferential surfaces of the spacers 42. Each linking element 33 thermally and mechanically connects the connecting sections 35 of embedded elements 32 of neighbouring magnet coils 31.

The linking element 33 may be configured to thermally and mechanically connect the connecting sections 35 of the plurality of embedded elements 32. In one embodiment, the linking element 33 forms a continuous structure (not shown) attached to the connecting elements 35 at each spacer 42. However, the linking element 33 may also comprise a plurality of disjoint or separate linking elements 33. Each linking element 33 of the plurality of disjoint or separate linking elements 33 may bridge a gap between two or more spacers 42.

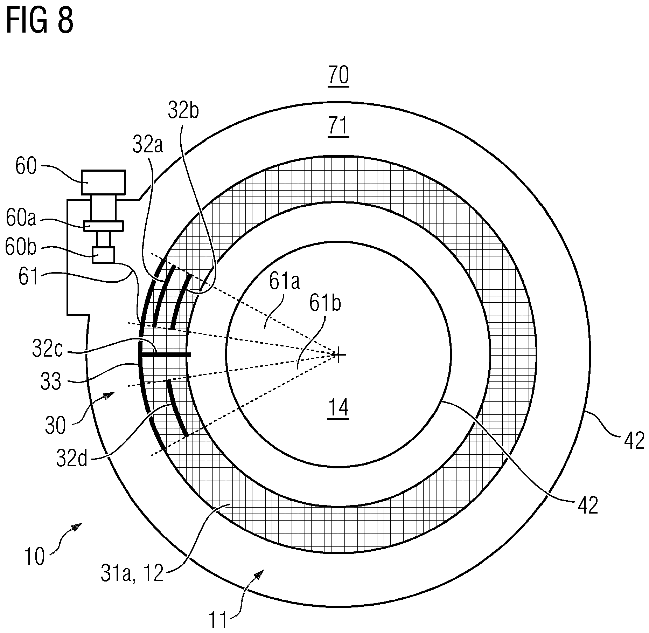

Preferably, the modular thermal bus 30 is mechanically and thermally attached to a cooling system of a magnetic resonance device 10, e. g. a cryocooler 60, a cold head of a cryocooler 60, a heat exchanger of a cryocooler 60, a cryogen vessel and/or a main thermal bus 61 (see Fig. 8).

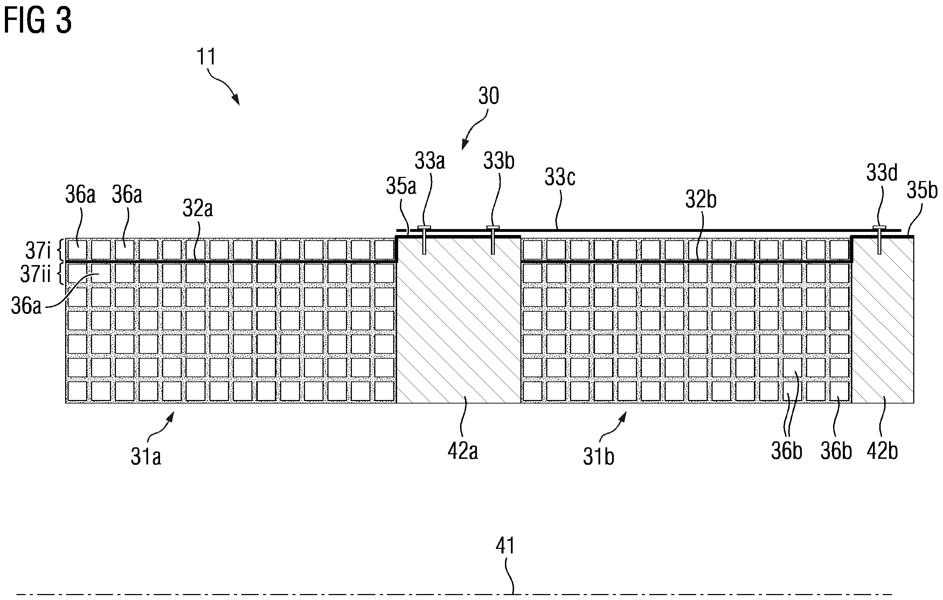

Fig. 3 shows a further embodiment of a modular thermal bus 30 of an inventive magnet arrangement 11. In the depicted example, a section of a magnet arrangement 11 comprising the magnet coils 31a and 31b is shown. The magnet coils 31a and 31b are separated by the spacer 42a. Further magnet coils may be attached to the spacer 42b.

The magnet coil 31a comprises a superconducting wire 36a wound in such a way to provide layers 37 of superconducting wire 36a. In the depicted example, the modular thermal bus 30 comprises an embedded elements 32a arranged between an outer layer 37i and a second layer 37ii of the superconducting wire of the magnet coil 31a. The embedded element 32a comprises a connecting section 35a protruding from the matrix structure of the magnet coil 31a in vicinity to the spacer 42a and bending or curving over the outer circumferential surface of the spacer 42a.

According to the embodiment shown in Fig. 3, a second embedded element 32b is also arranged between an outer layer 37i and a second layer 37ii of superconducting material of the magnet coil 31b. A connecting section 35b of the embedded element 32b protrudes from the superconducting material of the magnet coil 31b in vicinity to the spacer 42b and curves or bends over an outer circumferential surface 42b of the spacer 42b.

The linking element 33c provides a thermal connection between the magnet coil 31a and the magnet coil 31b by thermally and mechanically connecting to the connecting section 35a of the embedded element 32a and the connecting section 35b of the embedded element 32b embedded within the matrix structure of the magnet coil 31b. In the shown example, the linking element 33c is formed as a rod or plate configured to bridge a distance between the spacers 42a and 42b. The linking element 33c is attached or mounted to the spacers 42a and 42b via bolts 33a, 33b and 33d. The bolts 33a, 33b and 33d provide a thermal and mechanical connection between the linking element 33c, the connecting section 35a and the connecting section 35b.

Of course, the magnet arrangement 11 may comprise further magnet coils 31 thermally connected via a modular thermal bus in accordance with any embodiment described herein.

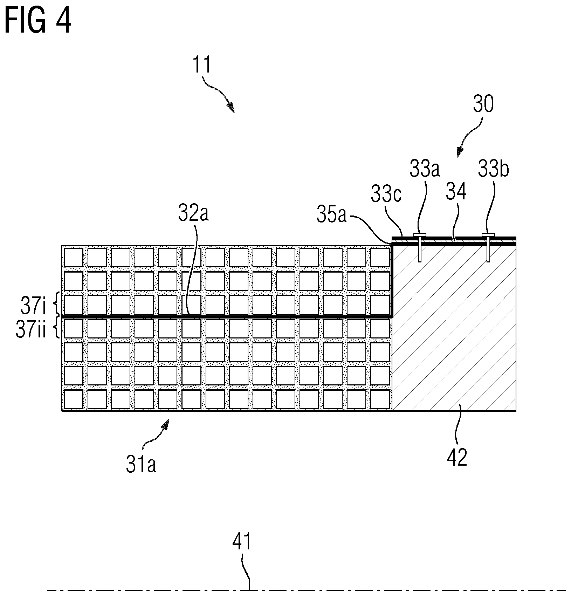

Fig. 4 shows a section of an inventive magnet arrangement 11 comprising a magnet coil 31a and a spacer 42. Sections of the modular thermal bus 30 depicted in Fig. 4 may be configured in accordance with sections of the modular thermal bus 30 depicted in Fig. 3. In comparison to the embodiment shown in Fig. 3, the embedded element 32a is embedded deeper within the matrix structure of the magnet coil 31a. For example, the embedded element 32a is embedded between a third layer 37iii and a fourth layer 37iv of superconducting wire of the magnet coil 31a. Furthermore, a thermally conductive element 34 is arranged between the connecting section 35a of the embedded element 32a and the linking element 33c.

The thermally conductive element 34 may comprise or consists of a thermally conductive glue, paste, or preferably, a soft metal such as indium. The thermally conductive element 34 may be configured to reduce voids or gaps between the connecting section 35a and the linking element 33c and/or increase a heat transfer area between the connecting section 35a and the linking element 33c.

A thermally conductive element 34 may be included in every embodiment described herein. Although Fig. 4 only shows a section of the inventive magnet arrangement 11 comprising the magnet coil 31a, the embedded element 32a, the spacer 42, and a section of a modular thermal bus 30, it is to be understood that one or more magnet coils 31 may be mechanically connected or coupled to the spacer 42. Said one or more magnet coils 31 may be thermally and mechanically connected to the modular thermal bus 30 in accordance with an embodiment described herein.

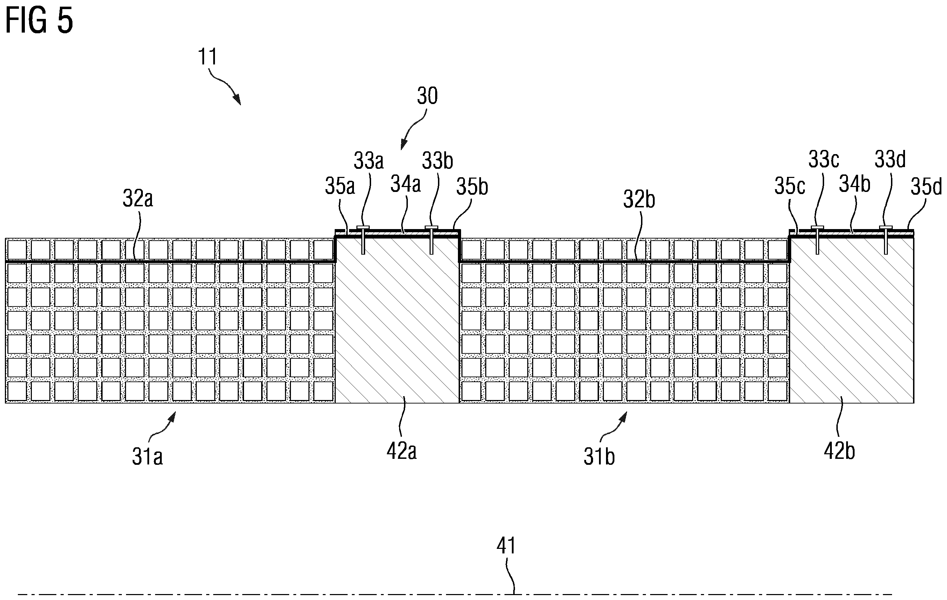

Fig. 5 depicts a section of an inventive magnet arrangement 11 comprising a magnet coil 31a and a magnet coil 31b separated via a spacer 42a. The embedded element 32a may be configured in accordance with the embedded elements 32 shown in Figs. 3 and 4. However, the embedded element 32b comprises two connecting sections 35b and 35c protruding from the matrix structure of the magnet coil 31b.

The connecting section 35b protrudes from the matrix structure of the magnet coil 31b in vicinity to the spacer 42a, whereas the connecting section 35c protrudes from the matrix structure of the magnet coil 31b in vicinity to the spacer 42b. In other words, the connecting sections 35b and 35c protrude from the matrix structure of the magnet coil 31b at opposing ends or opposing axial faces of the magnet coil 31b.

In the depicted example, the linking element 33 comprises bolts 33a, 33b and 33c, 33d configured to attach the connecting sections 35a, 35b and 35c, 35d to respective spacers 42a, 42b. The bolts 33a and 33b provide a thermal and mechanical connection between the connecting sections 35a and 35b, whereas the bolts 33c and 33d provide a thermal and mechanical connection between the connecting sections 35c and 35d. The connecting section 35d may represent a connecting section 35 of an embedded element 32 embedded within a further magnet coil 31 (not shown) attached or coupled to the spacer 42b. An embedded element 32 comprising the connecting section 35d may be configured in accordance with the embedded element 32a or the embedded element 32b as shown in Fig. 5.

In the example depicted in Fig. 5, thermally conductive elements 34a and 34b are arranged between the connecting sections 35a and 35b, and between the connecting sections 35d and 35c, respectively.

The magnet coil 31a may represent an end coil of the inventive magnet arrangement 11. In contrast, the magnet coil 31b may represent a bulk coil arranged between an end coil 31a and a further magnet coil 31c (not shown).

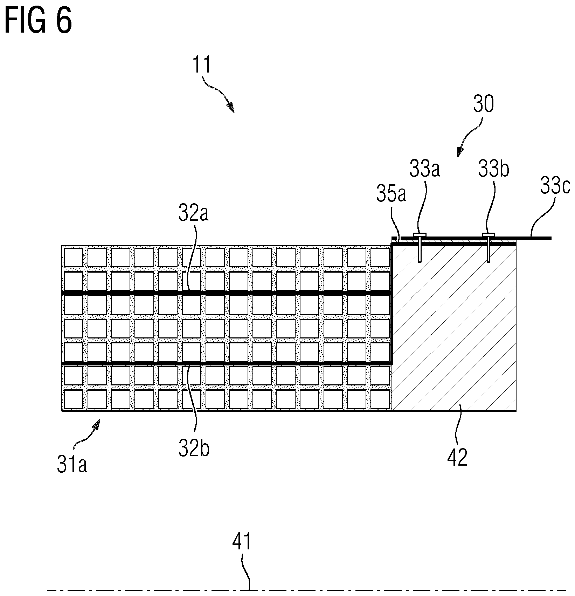

Fig. 6 depicts a further embodiment of a section of an inventive magnet arrangement 11. In the depicted example, two embedded elements 32a and 32b are embedded in the matrix structure of the magnet coil 31a. The two embedded elements 32a and 32b are embedded in the matrix structure of the magnet coil 31a at different depths or different radial distances from the cylinder axis 41 of the magnet arrangement 11. For example, the embedded element 32b is arranged closer to the cylinder axis 41 of the magnet arrangement 11 in comparison to the embedded element 32a.

The embedded elements 32a and 32b may share a connecting section 35a protruding from the matrix structure of the magnet coil 31a as depicted in Fig. 6. However, it is also conceivable that the embedded elements 32a and 32b comprise separate connecting sections 35 protruding from the superconducting material of the magnet coil 31 at the same location or at different locations. Preferably, the connecting section(s) 35 of the embedded elements 32a and 32b protrude from the matrix structure of the magnet coil 31 in vicinity to the spacer 42. The connecting section(s) 35 may be curved or bend over an outer circumferential surface of the spacer 42. The linking element 33c comprising the bolts 33a and 33b may be configured to attach the connecting section(s) 35 of the embedded elements 32a and 32b to the spacer 42 and thermally and mechanically connect the embedded elements 32a and 32b to further sections of the modular thermal bus 30 and further magnet coils 31 not shown in Fig. 6.

In the embodiments depicted in Figs. 2 to 6, the embedded element(s) 32 extend through the matrix structure of the magnet coil(s) 31 in parallel to the cylinder axis 41 or axis of rotational symmetry of the magnet arrangement 11.

In some embodiments, the magnet coil 31a may comprise further embedded elements 32 arranged in different cylinder sectors 61 of the magnet coil 31a. In the example depicted in Fig. 8, the cylinder sector 61a comprises the embedded elements 32a and 32b arranged at different radial distances from the cylinder axis 41 of the magnet arrangement 11 as shown in Fig. 6. The cylinder sector 61b of the magnet coil 31a comprises a further embedded element 32d. The embodiment of the magnetic resonance device 10 shown in Fig. 8 may represent an axial cross-section through the entire magnet coil 31a of a magnet arrangement 11 according to the invention. Of course, the magnet coil 31a may comprise further cylinder sectors 61 comprising embedded elements 32 in accordance with any embodiment described above.

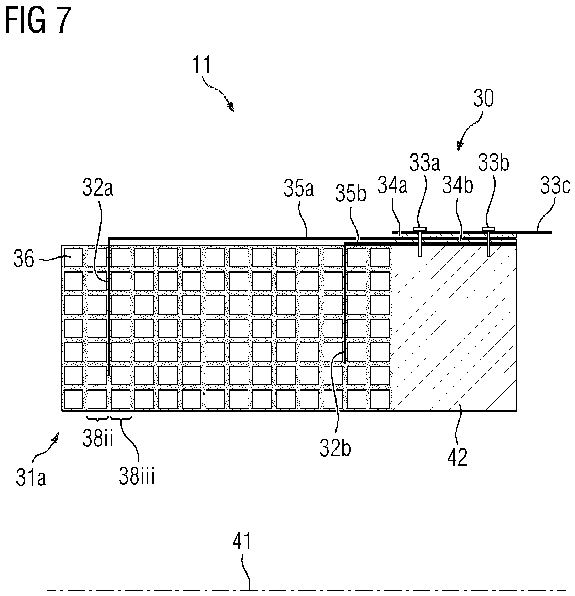

Fig. 7 shows an embodiment of a section of an inventive magnet arrangement 11. In the depicted example, the magnet coil 31a comprises embedded elements 32a and 32b extending through the matrix structure of the magnet coil 31a in a vertical or radial manner. For example, the embedded elements 32a and 32b may extend through the matrix structure of the magnet coil 31a in a direction oriented substantially orthogonal to the cylinder axis 41 of the magnet arrangement 11.

In contrast to the embodiments depicted in Figs. 2 to 6, the embedded elements 32a and 32b extend between columns 38 of superconducting wire rather than layers (i. e. rows or lines) of superconducting wires. For example, the embedded element 32a extends between the second column 38ii and the third column 38iii of the superconducting wire 36 within the matrix structure of the magnet coil 31a.

In order to facilitate manufacturing, the embedded elements 32a and 32b may start out as straight or planar pieces. The connecting sections 35a and 35b protruding from the matrix structure may be bend towards the spacer 42 after a winding process of the magnet coil 31a has finished. Thus, the connecting sections 35a and 35b do not interfere with the winding process.

In a further embodiment, spacers may be arranged between columns of the superconducting wire 36 when winding the magnet coil 31a. The spacers may be removed after the winding process has finished and the embedded elements 32a and 32b may be inserted into empty slots left by the spacers. For example, the embedded elements 32a and 32b may be glued into the empty slots via a thermally conductive adhesive.

In still a further embodiment, the magnet coil 31a may be subdivided into a number of individually wound sub-coils separated by the embedded elements 32a and 32b. Thus, embedded elements 32 may favourably be embedded within the matrix structure of the magnet coil 31a without impeding the winding process. The sub-coils may be electrically connected via conventional superconducting joints.

Preferably, the embedded elements 32a and 32b comprise separate connecting sections 35a and 35b protruding from the matrix structure of the magnet coil 31a at different locations. For example, the connecting sections 35a and 35b may protrude from the matrix structure of the magnet coil 31a at the locations, where the respective embedded elements 32a, 32b are embedded. However, the embedded elements 32a and 32b may also comprise sections (not shown) which extend between the layers of the superconducting wire in a direction oriented in parallel to the cylinder axis 41 of the magnet arrangement 11.

In the embodiment shown in Fig. 7, the linking element 33c comprises bolts 33a and 33b configured to attach the connecting sections 35a and 35b to an outer circumferential surface of the spacer 42. The linking element 33c thermally and mechanically connects the connecting sections 35a and 35 to each other, but also to further sections of the modular thermal bus 30.

The embedded elements 32a and 32b may penetrate the matrix of the magnet coil 31 to different depths. For example, the embedded elements 32a and 32b may have different extensions through the matrix structure of the first magnet coil 31a along the radial direction.

According to an alternative embodiment, the embedded elements 32a and 32b share a single connecting section 35 protruding from the matrix of the magnet coil 31a at one location.

Fig. 8 shows a sectional view of an embodiment of an inventive magnetic resonance device 10, for example an axial cross-section through the magnet coil 31a depicted in Fig. 6. The magnetic resonance device 10 comprises an outer vacuum chamber 42 providing an outer enclosure for the magnet arrangement 11. Particularly, the outer vacuum chamber 42 separates a surrounding environment 70 from a vacuum region 71 encompassed by the outer vacuum chamber 42. The outer vacuum chamber 42 may represent a double-walled hollow cylinder comprising an outer shell and an inner shell. The inner shell of the outer vacuum chamber 42 may represent a patient bore enclosing the imaging region 14 in a circumferential direction.

The magnetic resonance device 10 may further comprise a thermal shield (not shown). The thermal shield may also be embodied as double-walled hollow cylinders having an outer wall, an inner wall, and end walls connecting the outer wall and the inner wall. The outer wall and the inner wall of the thermal shield may circumferentially encompass the magnet arrangement 11 including the magnet coil 31a.

In the depicted example, the inventive magnetic resonance device 10 comprises a cryocooler 60 mounted on the outer vacuum chamber 42. The cryocooler 60 is configured to cool the magnet arrangement 11, but also any thermal shield, further thermal shield, magnet support structure , and/or cryogen vessel of the magnetic resonance device 10.

The cryocooler 60 typically comprises a compressor (not shown) supplying pressurized gas to the cryocooler 60. The cryocooler 60 may further include a cold head comprising one or more cooling stages. In a preferred embodiment, a first cooling stage 60a of the cold head is thermally connected to the thermal shield (not shown), whereas a second cooling stage 60b of the cold head is thermally connected to the magnet coil 31a via a main thermal bus 61 connected to the modular thermal bus 30. In one example, the first cooling stage 60a provides a temperature level of about 50 K, whereas the second cooling stage 60b provides a temperature level of about 4 K.

In "dry" magnetic resonance devices, the cooling stages 60a and 60b of the cryocooler 60 may be connected to the magnet arrangement 11 via a solid thermal conductor 61. However, the magnetic resonance device 10 may also comprise one or more small cryogen vessels or thermal buffers (not shown) thermally connected to the cryocooler 60 and/or the magnet arrangement 11 via a solid thermal conductor, a heat pipe, and/or a convective loop. Particularly, the one or more cryogen vessels or thermal buffers may be thermally connected to the magnet arrangement 11 via the modular thermal bus 30.

In the embodiment shown in Fig. 8, an extension of the embedded elements 32a, 32b and 32d within the matrix structure of the magnet coil 31a is limited to certain cylinder sectors 61a and 61b of the first magnet coil 31a. The cylinder sectors 61a and 61b may account for less than 80 %, less than 60 %, less than 40 %, or preferably less than 20 % of a circumference of the magnet coil 31a. In the depicted example, the cylinder sectors 61a and 61b account for less than 20 % of the circumference of the magnet coil 31a. In the depicted example, the cylinder sector 61a of the magnet coil 31a comprises the embedded elements 32a and 32b arranged at different radial distances from the cylinder axis 41 of the magnet arrangement 11 as shown in Fig. 6. The cylinder sector 61b comprises a further embedded element 32d extending through the matrix structure of the first magnet coil 31a in parallel to the cylinder axis 41 of the first magnet coil 31a.

The modular thermal bus 30 also comprises an embedded element 32c extending through the matrix structure of the magnet coil 31a in a radial direction. As the cylinder sector defined by the embedded element 32c is insignificant in comparison to the cylinder sectors 61a and 61b, it may be neglected.

In the embodiments described above, superconducting coils 31 (i. e. magnet coils) may be serially bonded via spacers 42 and embedded elements 32 of a modular thermal bus 30 may be embedded within the matrix structures of said superconducting coils 31. The embedded elements 32 may be thermally and mechanically connected to a linking element 33 of a modular thermal bus 30 configured to thermally connect the superconducting coils 31 to a cooling system, e. g. a heat exchanger of a cryocooler 60, a cryogen vessel and/or a main thermal bus 61 (see Fig. 8). Preferably, thermally conductive elements 34 are arranged between connecting sections 35 of the embedded elements 32 and the linking elements 33 to improve the thermal contact.

The magnet arrangement 11 according to the invention may comprise on or more modular thermal buses 30 distributed in regular or irregular intervals around the circumference of the magnet coils 31 of the magnet arrangement 11.

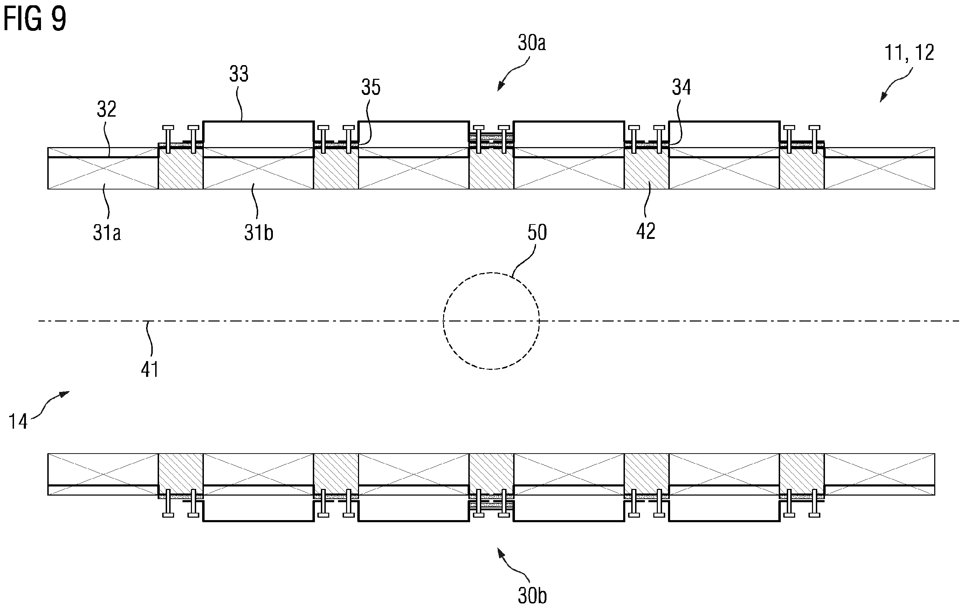

For example, Fig. 9 shows an embodiment of an inventive magnet arrangement 11 comprising two modular thermal buses 30a and 30b arranged at opposite sides of the magnet arrangement 11. In the depicted example, the modular thermal buses 30a and 30b are configured identically and thus, the labelling of elements of the modular thermal bus 30b has been omitted. However, each modular thermal bus 30a, 30b may be configured in accordance with any of the embodiments described herein.

In providing a plurality of modular thermal buses 30 distributed over a circumference of the magnet arrangement 11, a heat transfer capacity between the magnet coils 31 and the cooling system of a magnetic resonance device may favourably be increased or improved. Furthermore, a plurality of modular thermal buses 30 may favourably even out a heat distribution in a circumferential direction of the magnet arrangement 11.

In the depicted example, the linking elements 33 are shaped in such a way to allow for a tool and/or a hand of a technician to be arranged between the outer circumferential surface of the magnet coils 31 and the linking elements 33. Particularly, sections of the linking elements 33 bridging the space between two neighbouring spacers 42 are raised, angled and/or bend in such a way to provide a predetermined gap between the outer circumferential surface of the magnet coils 31 and the linking elements 33.

In providing linking elements 33 with raised sections, an assembly or disassembly of the modular thermal bus 30 may favourably be facilitated.

The embodiments described herein are to be recognized as examples. It is to be understood that individual embodiments may be extended by or combined with features of other embodiments if not explicitly stated otherwise. The embodiments depicted in the Figs. 1 to 9 are representations that do not necessarily have to be to scale.

## Claims

1. Magnet arrangement (11) for a magnetic resonance device (10), comprising a first magnet coil (31a), a second magnet coil (31b) and a modular thermal bus (30), wherein the first magnet coil (31a) and the second magnet coil (31b) each comprise a superconducting wire (36) arranged in a matrix structure and wherein the modular thermal bus (30) comprises an embedded element (32) and a linking element (33), wherein the embedded element (32) is embedded within the matrix structure of the first magnet coil (31a) and wherein the embedded element (32) and the second magnet coil (31b) are thermally and mechanically connected via the linking element (33).

2. The magnet arrangement (11) according to claim 1, wherein the first magnet coil (31a) and the second magnet coil (31b) are spaced apart from one another.

3. The magnet arrangement (11) according to claim 2, wherein the first magnet coil (31a) and the second magnet coil (31b) are spaced apart via at least one spacer (42) arranged between the first magnet coil (31a) and the second magnet coil (31b).

4. The magnet arrangement (11) according to one of the preceding claims, wherein the embedded element (32) comprises a connecting section (35) protruding from the matrix structure of the first magnet coil (31) and wherein the linking element (33) is thermally and mechanically connected to the connecting section (35).

5. The magnet arrangement (11) according to claims 3 and 4, wherein the first magnet coil (31a) and the at least one spacer (42) comprise a cylindrical shape, wherein the connecting section (35) is arranged on an outer circumferential surface of the at least one spacer (42) and wherein the linking element (33) is mechanically connected to the at least one spacer (42) and the connecting section (35) at the outer circumferential surface of the at least one spacer (42).

6. The magnet arrangement according to one of the claims 4 or 5, wherein the first magnet coil (31a) comprises a cylindrical shape and wherein the embedded element (32) comprises two connecting sections (35) protruding from the matrix structure of the first magnet coil (31a) at opposing axial ends of the first magnet coil (31a).

7. The magnet arrangement (11) according to one of the preceding claims, comprising a thermally conductive element (34) arranged between the embedded element (32) and the linking element (33).

8. The magnet arrangement (11) according to one of the preceding claims, wherein the first magnet coil (31a) comprises a cylindrical shape and wherein a section of the embedded element (31) extends through the matrix structure of the first magnet coil (31a) in parallel to a cylinder axis (41) of the first magnet coil (31a).

9. The magnet arrangement (11) according to one of the preceding claims, wherein the first magnet coil (31a) comprises a cylindrical shape and wherein a section of the embedded element (32) extends through the matrix structure of the first magnet coil (31a) in a radial direction of the first magnet coil (31a).

10. The magnet arrangement (11) according to one of the preceding claims, wherein the first magnet coil (31a) comprises a cylindrical shape, and wherein an extension of the embedded element (32) within the matrix structure of the first magnet coil (31a) is limited to a cylinder sector (61) of the first magnet coil (31a), wherein the cylinder sector (61) accounts for less than 80%, less than 60%, less than 40%, or preferably less than 20% of a circumference of the first magnet coil (31a).

11. The magnet arrangement (11) according to one of the preceding claims, comprising a plurality of embedded elements (32) embedded within the matrix structure of the first magnet coil (31a) and/or the second magnet coil (31b), wherein the plurality of embedded elements (32) is thermally and mechanically connected via one or more linking elements (33).

12. The magnet arrangement (11) according to claim 11, wherein at least two embedded elements (32) of the plurality of embedded elements (32) are embedded within the matrix structure of the first magnet coil (31a) at different depths.

13. The magnet arrangement (11) according to one of the preceding claims, wherein a third magnet coil is arranged between the first magnet coil (31a) and the second magnet coil (31b).

14. The magnet arrangement (11) according to one of the preceding claims, wherein the modular thermal bus (30) comprises a first embedded element (32a) and a second embedded element (32b), wherein the first embedded element (32a) is embedded within the first magnet coil (31a) and the second embedded element (32b) is embedded within the second magnet coil (31b), wherein the first embedded element (32a) and the second embedded element (32b) are thermally and mechanically connected via the linking element (33).

15. The magnet arrangement (11) according to claim 14, wherein the first embedded element (31a) and the second embedded element (31b) each comprise a connecting section (35a; 35b), wherein the connecting sections (35a; 35b) of the first embedded element (31a) and the second embedded element (31b) overlap along an axial section of the magnet arrangement (11), and wherein the linking element (33) is configured to thermally and mechanically connect the connecting sections (35a; 35b) of the first embedded element (32a) and the second embedded element (32b).

16. Magnetic resonance device (10) for acquiring magnetic resonance data of an object positioned within an imaging region (14) of the magnetic resonance device (10), comprising a magnet arrangement (11) according to one of the preceding claims.
